# FASCICULE DE BREVET EUROPEEN

(11) **EP 0 576 375 B1**
(45) Date de publication et mention de la délivrance du brevet: **28.05.1997**
(21) Numéro de dépôt: 93420262.3
(22) Date de dépôt: 22.06.1993
(51) Int. Cl.: H01L 23/60, H01L 27/06

(54) **Structure de diodes de protection de plot**
Diodenstruktur zum Schutz von IC-Anschlüssen
Diode structure for pad protection

(30) Priorité: 25.06.1992 FR 9208280
(43) Date de publication de la demande: 29.12.1993
(73) Titulaire: SGS-THOMSON MICROELECTRONICS S.A., 94250 Gentilly (FR)
(72) Inventeur: Jimenez, Jean, F-38500 Voiron (FR)
(74) Mandataire: de Beaumont, Michel

(56) Documents cités:
- EP-A- 0 401 135
- INTERNATIONAL ELECTRON DEVICES MEETING Décembre 1990, SAN FRANCISCO, CA, USA pages 799 - 802 , XP279627 M. P. MASQUELIER ET AL. 'METHOD OF INTERNAL OVERVOLTAGE PROTECTION AND CURRENT LIMIT FOR A LATERAL PNP TRANSISTOR FORMED BY POLYSILICON SELF-ALIGNED EMITTER AND BASE, WITH EXTENDED COLLECTOR'
- PATENT ABSTRACTS OF JAPAN vol. 13, no. 220 (E-762)(3568) 23 Mai 1989 & JP-A-10 32 666

## Description

La présente invention concerne la protection de plots de circuit intégré contre des décharges électrostatiques.

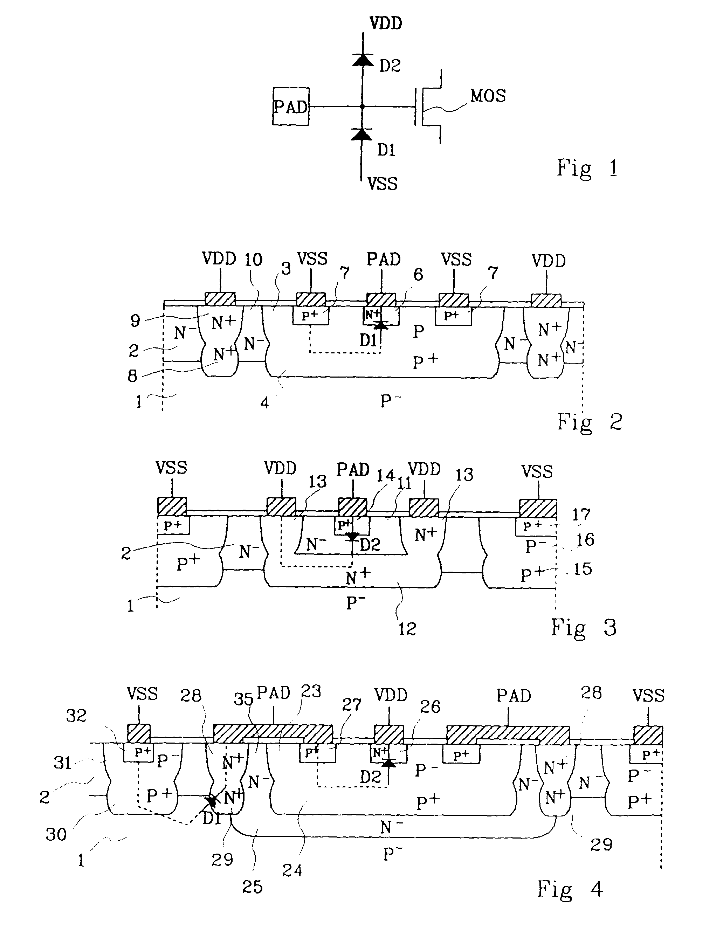

Comme cela est connu, un circuit intégré est relié à des circuits extérieurs par des plots d'entrée et de sortie eux-mêmes reliés à des broches. Les composants internes d'un circuit intégré sont généralement sensibles à l'apparition de surcharges électrostatiques qui sont susceptibles de les détruire. Ainsi, on associe généralement à chaque plot d'un circuit intégré une structure de protection contre les décharges électrostatiques dont un exemple simple est illustré sous forme de circuit en figure 1.

La figure 1 représente un plot PAD relié, à titre d'exemple, à la grille d'entrée d'un transistor MOS. Le circuit intégré est alimenté entre une tension d'alimentation haute VDD et une tension d'alimentation basse VSS, par exemple la masse. Le plot est relié aux bornes d'alimentation basse et haute par des diodes D1 et D2 polarisées de la façon représentée. Ainsi, si le plot devient plus négatif que VSS (moins une chute de tension de diode en direct) la surtension passe par la diode D1 et est absorbée par VSS. Si le plot devient plus positif que VDD (plus une chute de tension de diode en direct) la surtension passe par la diode D2 et est absorbée par VDD. Dans les deux cas, le dispositif connecté au plot, par exemple un transistor MOS, est protégé.

La présente invention se place plus particulièrement dans le cadre d'une technologie telle que par exemple celle utilisée pour la réalisation de circuits intégrés mixtes bipolaire et MOS (BICMOS) utilisant un substrat d'un premier type de conductivité revêtu d'une couche épitaxiée du deuxième type de conductivité. Cette technologie comprend des moyens pour former à l'interface entre le substrat et la couche épitaxiée des couches enterrées de type N ou P et des moyens pour former dans la couche épitaxiée des caissons du premier type de conductivité et bien entendu diverses régions dopées du type N ou P dans les caissons et dans le substrat à partir de la surface du circuit intégré.

Les figures 2 et 3 représentent des structures classiques utilisées dans l'art antérieur pour réaliser respectivement les diodes D1 et D2 de la figure 1 dans le cas où le substrat 1 est de type P et la couche épitaxiée 2 de type N.

La figure 2 représente un mode de réalisation classique de la diode D1 de la figure 1. Cette diode est formée dans un caisson 3 de type P rejoignant par sa face inférieure une couche enterrée de type P fortement dopée 4. A partir de la surface du caisson sont formées une première région 6 de type N et une deuxième région 7 de type P. La région 7 est par exemple une région annulaire entourant la région 6. La région 7 qui est en continuité électrique avec le substrat 1 par l'intermédiaire du caisson 3 et de la couche enterrée 4 est nécessairement polarisée au potentiel du substrat, le potentiel bas VSS. La région 6 est reliée au plot PAD. Ainsi, la diode D1 est formée à la jonction entre le caisson 3 et la région 6 de la façon illustrée. On a en outre représenté, en dehors du caisson, une portion 10 de la couche épitaxiée 2 et un anneau de type N⁺ constitué de l'ensemble d'une couche enterrée 8 et d'une diffusion profonde 9 de type N⁺ la face supérieure de la région 9 étant solidaire d'une métallisation reliée au potentiel haut VDD. Cet anneau est destiné à assurer la polarisation de la portion 10 de la couche épitaxiée qui constitue le collecteur d'un transistor NPN dont la jonction émetteur-base correspond à la diode D1 et qui collecte les charges émises quand cette diode est passante.

En outre la structure est entourée d'une prise substrat telle que cette décrite ci-après en relation avec la figure 3 pour isoler la portion de couche épitaxiée 10 et l'anneau N⁺ 8-9.

La figure 3 représente un exemple de réalisation classique de la diode D2 de la figure 2. La diode D2 est réalisée dans une partie 11 de la couche épitaxiée 2 sous laquelle est formée une couche enterrée 12 de type N⁺. Un anneau diffusé 13 de type N⁺ rejoint la couche enterrée 12 et permet de prendre un contact avec celle-ci et d'isoler la partie 11. Une région 14 de type P⁺ est diffusée dans la portion de couche 11. La région 14 est reliée à la métallisation de plot PAD et la surface supérieure de la région 13 est reliée à la tension VDD. Ainsi, la diode D2 est formée à la jonction entre la région 14 et la portion de couche N 11. On a représenté à la périphérie de la structure précédemment décrite une prise substrat, c'est-a-dire une couche enterrée 15 de type P⁺ rejointe par une diffusion de type P 16 à la surface de laquelle est formée une région diffusée de type P⁺ 17 solidaire d'un contact de polarisation de substrat au potentiel VSS. Cette prise substrat constitue le collecteur d'un transistor PNP dont la jonction émetteur-base correspond à la diode D2 et qui collecte les charges émises quand cette diode est passante.

La figure 3 a été représentée séparément de la figure 2 bien qu'en pratique les deux diodes D1 et D2 soient réalisées sur un même circuit intégré et éventuellement de façon adjacente.

La présente invention vise à prévoir une structure combinant les diodes D1 et D2 précédemment décrites et occupant une surface de silicium aussi faible que possible.

Un autre objet de la présente invention est de prévoir une telle structure compatible avec les étapes technologiques classiques de fabrication d'un circuit intégré tel qu'un circuit intégré BICMOS.

Ces objets sont atteints en prévoyant une structure de diodes de protection d'un plot contre des décharges électrostatiques dans un circuit intégré formé dans un substrat d'un premier type de conductivité et alimenté entre une première borne d'alimentation reliée au substrat et une deuxième borne d'alimentation. Cette structure comprend un caisson du premier type de conductivité dont les bords et le fond sont entourés d'une région du deuxième type de conductivité dont le fond est en contact avec le substrat, une zone du deuxième type de conductivité formée dans le caisson, un anneau du deuxième type de conductivité entourant latéralement la région du deuxième type de conductivité et rejoignant le substrat, et un puits de prise de contact avec le substrat, entourant l'anneau. Un premier contact est formé avec l'anneau, un deuxième avec le caisson, un troisième avec ladite zone et un quatrième contact avec le puits. Les premier et deuxième contacts sont reliés au plot, le troisième à la deuxième borne d'alimentation et le quatrième à la première borne d'alimentation.

Selon un mode de réalisation de la présente invention, le fond du caisson est constitué d'une première portion de couche enterrée du premier type de conductivité à fort niveau de dopage formée dans une deuxième portion de couche enterrée du deuxième type de conductivité à faible niveau de dopage interposée entre la première couche enterrée et le substrat.

Selon un mode de réalisation de la présente invention, le substrat est recouvert d'une couche épitaxiée du deuxième type de conductivité dans laquelle est formé le caisson, une portion de cette couche épitaxiée subsistant entre le caisson et l'anneau.

Ces objets, caractéristiques et avantages ainsi que d'autres de la présente invention seront exposés en détail dans la description suivante de modes de réalisation particuliers faite en relation avec les figures jointes parmi lesquelles :
les figures 1 à 3 décrites précédemment sont destinées à illustrer le problème posé et des solutions de l'art antérieur ;
la figure 4 représente une vue en coupe d'une structure de diodes de protection d'un plot de circuit intégré selon la présente invention.

On notera que les figures 2, 3 et 4 qui représentent des vues en coupe partielles de circuits intégrés sont très schématiques et ne sont pas tracées à l'échelle. En outre, les coins des diverses couches ont été représentées par simplification avec des angles droits alors qu'en fait, comme cela est connu de l'homme de métier, les étapes de diffusion et de recuit amènent à des formes arrondies.

La présente invention prévoit de former un ensemble de deux diodes D1 et D2 dans lequel la diode D2 est formée dans un caisson P isolé par une région de type N qui l'entoure complètement. En effet, il est connu dans des filières technologiques de type BICMOS telles que décrites par exemple dans la demande de brevet européen EP-A-0 401135 déposée sous une priorité du 2 juin 1989 par la demanderesse au nom du même inventeur, de prévoir une couche enterrée de type N à faible niveau de dopage qui peut être formée sous une région enterrée de type P⁺. Ainsi, la réalisation de la couche N isolant complétement le caisson P utilisé selon l'invention n'implique pas la mise en oeuvre d'étapes technologiques nouvelles par rapport aux étapes technologiques classiques utilisées en technologie BICMOS.

Plus particulièrement, la figure 4 représente une portion d'un circuit intégré formé dans un substrat 1 de type P au-dessus duquel est réalisée une couche épitaxiée 2 de type N. Dans la couche épitaxiée 2 est formée un caisson 23 de type P qui rejoint une couche enterrée 24 de type P⁺. La couche 24 est elle-même formée au-dessus d'une couche enterrée 25 de type N⁻ qui présente une interface avec le substrat 1. Dans le caisson 23 sont formées des régions 26 de type N et des régions 27 de type P. Autour du caisson 23 est formé un mur ou anneau de type N constitué d'une portion de couche enterrée 29 de type N⁺ et d'une région de diffusion profonde 28 qui rejoint cette portion de couche enterrée. A l'extérieur du dispositif sont prévues des régions de prise de contact substrat comprenant une région enterrée 30 de type P⁺ que rejoint une diffusion profonde 31 de type P dans laquelle sont formées des régions de prise de contact de type P plus fortement dopées 32.

Le plot PAD est relié à des métallisations en contact avec la région 29 et avec la partie supérieure 28 du mur de type N. La prise de contact de substrat est bien entendu reliée au potentiel VSS pour assurer la polarisation du substrat et la région 26 de type N⁺ du caisson est reliée au potentiel VDD. En effet, grâce à la présente invention, le caisson 23, qui est complètement entouré de la région N constituée par la couche enterrée 25 et une portion 35 de la couche épitaxiée 2, peut être mis à un potentiel choisi et n'est plus nécessairement au potentiel VSS comme dans le cas représenté en figure 2. Avec cette structure, on obtient la diode D2 à l'interface entre la région N⁺ 26 et le caisson P 23 et la diode D1 à l'interface entre le mur de type N 28-29 et le substrat 1. On a représenté en pointillés dans les diverses figures et de façon très schématique les trajets de circulation de courant dans ces diodes entre les métallisations.

Ainsi, grâce à la présente invention, on réalise les diodes D1 et D2 dans une surface qui n'est pas supérieure à celle utilisée dans l'art antérieur pour réaliser la seule diode D1, comme on peut le voir en comparant les figures 2 et 4 (en se rappelant qu'en figure 2 la structure est entourée d'une prise substrat non représentée.

Bien que la présente invention ait été décrite dans le cadre d'une technologie particulière, elle s'applique à d'autres technologies, par exemple dans lesquelles tous les types de conductivité de matériaux semiconducteurs et les polarités des tensions appliquées sont inversés.

La présente invention est susceptible de diverses variantes qui apparaitront à l'homme de métier. Notamment, on n'a représenté que des vues en coupe de structures de protection. De façon classique, les diverses régions et anneaux auront des formes rectangulaires.

## Revendications

1. Circuit intégré formé dans un substrat d'un premier type de conductivité et alimenté entre une première borne d'alimentation (VSS) reliée au substrat et une deuxième borne d'alimentation (VDD) comprenant une structure de diodes de protection d'un plot contre des décharges électrostatiques, ladite structure de diodes comprenant:
un caisson (23) du premier type de conductivité dont les bords et le fond sont en contact avec une région (25, 35) du deuxième type de conductivité dont le fond est en contact avec ledit substrat,
une zone (26) du deuxième type de conductivité formée dans ledit caisson,
un anneau (28, 29) du deuxième type de conductivité entourant latéralement ledit caisson et rejoignant ledit substrat,
un puits (30, 31, 32) du premier type de conductivité de prise de contact avec le substrat, entourant ledit anneau,
un premier contact avec ledit anneau,
un deuxième contact avec ledit caisson,
un troisième contact avec ladite zone,
un quatrième contact avec ledit puits,
des moyens pour relier les premier et deuxième contacts au plot,
des moyens pour relier le troisième contact à la deuxième borne d'alimentation, et
des moyens pour relier le quatrième contact à la première borne d'alimentation.

2. Circuit intégré comprenant une structure de diodes de protection selon la revendication 1, caractérisé en ce que le fond du caisson (23) est constitué d'une première portion de couche enterrée du premier type de conductivité à fort niveau de dopage (24) formée dans une deuxième portion de couche enterrée du deuxième type de conductivité à faible niveau de dopage (25) interposée entre la première couche enterrée et le substrat.

3. Circuit intégré comprenant une structure de diodes de protection selon la revendication 1, caractérisé en ce que le substrat (1) est recouvert d'une couche épitaxiée (2) du deuxième type de conductivité dans laquelle est formé le caisson, une portion de cette couche épitaxiée subsistant entre ledit caisson et ledit anneau.

## Claims

1. An integrated circuit formed in a substrate of a first conductivity type and fed between a first supply terminal (VSS) connected to the substrate and a second supply terminal (VDD), including diode structure for protecting a pad against electrostatic discharges, said diode structure comprising:
a pocket (23) of the first conductivity type whose edges and bottom contact a region (25, 35) of the second conductivity type, the bottom of which contacts said substrate,
an area (26) of the second conductivity type formed in said pocket (23),
a ring (28, 29) of the second conductivity type laterally surrounding said pocket and contacting said substrate,
a well (30, 31, 32) of the first conductivity type contacting the substrate, surrounding said ring (27, 28),
a first contact with said ring,
a second contact with said pocket,
a third contact with said area,
a fourth contact with said well,
means for connecting said first and second contacts to the pad,
means for connecting the third contact to the second supply terminal, and
means for connecting said fourth contact to the first supply terminal.

2. An integrated structure including a protection diode structure according to claim 1, characterized in that the bottom of said pocket (23) is formed by a first portion of an high doped buried layer (24) of the first conductivity type formed in a second portion of a low doped buried layer of the second conductivity type (25) sandwiched between said first buried layer and the substrate.

3. AN integrated circuit including a protection diode structure according to claim 1, characterized in that said substrate (1) is coated with an epitaxial layer (2) of the second conductivity type in which is formed the pocket, a portion of said epitaxial layer remaining between said pocket and said ring.

## Patentansprüche

1. Integrierte Schaltung, welche in einem Substrat eines ersten Leitfähigkeitstyps ausgebildet ist und zwischen einem ersten Versorgungsanschluß (VSS), welcher mit dem Substrat verbunden ist, und einem zweiten Versorgungsanschluß (VDD) versorgt wird, mit einer Diodenstruktur zum Schützen einer Anschlußstelle gegen elektrostatische Entladungen, bei der die Diodenstruktur folgende Merkmale aufweist:
eine Senke (23) des ersten Leitfähigkeitstyps, deren Ränder und Boden in Kontakt mit einem Bereich (25,35) des zweiten Leitfähigkeitstyps ist, dessen Boden in Kontakt mit dem Substrat ist,
eine Zone (26) des zweiten Leitfähigkeitstyps, welche in der Senke ausgebildet ist,
einen Ring (28,29) des zweiten Leitfähigkeitstyps, welcher die Senke seitlich umgibt und das Substrat berührt, einen Schacht (30, 31, 32) des ersten Leitfähigkeitstyps in Kontakt mit dem Substrat, welcher den Ring umgibt,
einen ersten Kontakt mit dem Ring,
einen zweiten Kontakt mit der Senke,
einen dritten Kontakt mit der Zone,
einen vierten Kontakt mit dem Schacht,
Mittel zum Verbinden des ersten und des zweiten Kontakts mit der Anschlußstelle,
Mittel zum Verbinden des dritten Kontakts mit dem zweiten Versorgungsanschluß und
Mittel zum Verbinden des vierten Kontakts mit dem ersten Versorgungsanschluß.

2. Integrierte Schaltung mit einer Schutzdiodenstruktur nach Anspruch 1, dadurch **gekennzeichnet**, daß der Boden der Senke (23) von einem ersten Teil einer hoch dotierten vergrabenen Schicht (24) des ersten Leitfähigkeitstyps gebildet ist, welche in einem zweiten Teil einer niedrig dotierten vergrabenen Schicht des zweiten Leitfähigkeitstyps (25) ausgebildet ist, die zwischen der ersten vergrabenen Schicht und dem Substrat liegt.

3. Integrierte Schaltung mit einer Schutzdiodenstruktur nach Anspruch 1, dadurch **gekennzeichnet**, daß das Substrat (1) mit einer Epitaxieschicht (2) des zweiten Leitfähigkeitstyps überdeckt ist, in welcher die Senke ausgebildet ist, wobei ein Teil dieser Epitaxieschicht zwischen der Senke und dem Ring bleibt.
